# EUROPÄISCHE PATENTSCHRIFT

(11) **EP 2 515 440 B1**
(45) Veröffentlichungstag und Bekanntmachung des Hinweises auf die Patenterteilung: **01.03.2017**
(21) Anmeldenummer: 12002434.4
(22) Anmeldetag: 04.04.2012
(51) Int. Cl.: H03K 17/95

(54) **Induktiver Näherungs- oder Abstandssensor**
Inductive proximity or distance sensor
Capteur de proximité ou de rapprochement inductif

(30) Priorität: 19.04.2011 DE 102011018167
(43) Veröffentlichungstag der Anmeldung: 24.10.2012
(73) Patentinhaber: Diehl Aerospace GmbH, 88662 Überlingen (DE)
(72) Erfinder: Trunk, Lothar, 63879 Weibersbrunn (DE); Houp, Alan Lowell, 60598 Frankfurt a. Main (DE)
(74) Vertreter: Diehl Patentabteilung

(56) Entgegenhaltungen:
- US-A1- 2001 019 262
- US-A1- 2006 103 372
- US-B1- 6 236 200

## Beschreibung

Die Erfindung betrifft insbesondere einen induktiven Näherungs- oder Abstandssensor. Solche Sensoren sind beispielsweise aus der DE 1 03 28 122 A1, der US 2001/0019262 A1 oder der DE 102009037808 A1 bekannt.

Bei der Verwendung solcher Näherungs- bzw. Abstandssensoren in Sicherheitskritischen Bereichen wird eine hohe Genauigkeit insbesondere bei sich verändernden Gesamtumständen, wie beispielsweise Temperaturschwankungen und dgl. gefordert.

Zwar weisen die bekannten Konstruktionen und Aufbauten durchaus zufriedenstellende Genauigkeiten auf. Ungeachtet dessen gibt es dennoch Raum und für zusätzliche Verbesserungen zur Steigerung der Genauigkeit und Zuverlässigkeit.

Ausgehend davon ist es eine Aufgabe der vorliegenden Erfindung die nach dem Stand der Technik bekannten Systeme zu verbessern. Es soll insbesondere ein Sensor, insbesondere ein Näherungs- bzw. Abstandssensor, mit verbesserter Empfindlichkeit, Genauigkeit und Zuverlässigkeit angegeben werden, welcher - unter anderem - auch vergleichsweise einfach und kostengünstig hergestellt werden kann.

Diese Aufgabe wird gelöst durch die Merkmale des unabhängigen Anspruchs. Ausgestaltungen ergeben sich aus den abhängigen Ansprüchen.

Gemäß dem unabhängigen Patentanspruch 1 wird ein Sensor mit einer induktiven Sensoreinheit vorgeschlagen, welche zumindest einen Spulenträger mit einer darauf befindlichen Spulenwicklung zur Erzeugung eines Magnetfelds und zumindest einen Kern aufweist.

Dabei erstreckt sich die Spulenwicklung in axialer Richtung unmittelbar angrenzend an eine erste axiale Anlagefläche des Spulenträgers. Die erste axiale Anlagefläche kann beispielsweise durch einen flanschartigen Vorsprung oder durch einen, zu einem flanschartigen Vorsprung führenden Einschnitt im Spulenkörper gebildet sein.

Vorteilhafter Weise erstreckt sich die Spulenwicklung in Axialrichtung des Spulenträgers bis zu einer weiteren axialen Anlagefläche, was bedeutet, dass sich die Spulenwicklung zwischen der ersten und der weiteren axialen Anlagenfläche erstreckt. Konstruktionsbedingt kann, und wird sich, der Kern üblicherweise über die weitere axiale Anlagefläche hinweg erstrecken.

Der Spulenträger als solcher kann im Querschnitt rund, oval, viereckig, rechteckig, usw. ausgebildet sein. Als Material für den Spulenkörper eignen sich insbesondere Kunststoffe, wie z. B. PEEK.

Der Kern ist zumindest teilweise in einer Ausnehmung im Spulenträger konzentrisch und überlappend mit der Spulenwicklung angeordnet. Konzentrisch soll insbesondere bedeuten, dass der Kern zentral bzw. mittig in der durch die Spulenwicklung ausgebildeten Spule liegt. Vorzugsweise ist die Ausnehmung an die äußeren Abmessungen und die äußere Form des in die Ausnehmung ragenden Abschnitt des Kerns angepasst.

Der Kern liegt an einer zur ersten axialen Anlagefläche im Wesentlichen koplanaren zweiten axialen Anlagefläche an. Dadurch, dass die erste und zweite axiale Anlagefläche koplanar gelegen sind, kann vermieden werden, dass durch Temperaturschwankungen die relative Lage der an entsprechenden axialen Anlageflächen anliegenden Enden von Spulenwicklung und Kern verändert wird. Auf diese Weise kann ein gegenüber Temperaturschwankungen vergleichsweise unempfindlicher Sensor erhalten werden.

Bei dem vorgeschlagenen Sensor weist zumindest ein mit der Spulenwicklung überlappender Kernabschnitt ein rechteckförmiges Querschnittsprofil auf. Überraschenderweise wurde gefunden, dass mit einem solchen Querschnittsprofil eine besonders hohe Genauigkeit und Zuverlässigkeit erreicht werden kann.

Unter der Formulierung "ein mit der Spulenwicklung überlappender Kernabschnitt" soll insbesondere ein Abschnitt des Kerns verstanden werden, welcher sich in der Ausnehmung befindlich, von der Ebene der ersten axialen Anlagefläche weg axial über die axiale Erstreckung der Spulenwicklung hinweg erstreckt. Anders ausgedrückt liegt der Kernabschnitt im Inneren der durch die Spulenwicklung ausgebildeten Spule.

Die Form der Windungen bzw. Wicklungen der Spule ergibt sich aus der entsprechenden Form des Spulenträgers. Dieser kann im Bereich der Spulenwicklung insbesondere einen kreisförmigen, ovalen, polygonen, viereckigen, rechteckigen usw. Querschnitt aufweisen. Bevorzugt sind Ecken oder Kanten des Spulenträgers im Bereich der Spulenwicklung abgerundet, so dass Beschädigungen des Spulenmaterials, d. h. des Wickeldrahts, vermieden werden können.

Der Kern kann aus einem Metall, insbesondere aus Mu-Metall bzw. Permalloy, hergestellt sein. Das Spulenmaterial, insbesondere die Wickeldrähte für die Spule, können aus Kupfer oder einer Kupferlegierung hergestellt sein.

Nach einer Variante ist das Querschnittsprofil zumindest eines Kernabschnitts ein Vollprofil. D. h., dass der Kern zumindest einen Kernabschnitt aufweist, welcher aus Vollmaterial hergestellt ist. Für ein Vollprofil ergibt sich eine besonders vorteilhafte Empfindlichkeit des Sensors.

Nach einer anderen Variante ist das Querschnittsprofil zumindest eines Kernabschnitts des Kerns ein geschlossenes oder ein offenes Hohlprofil. Kerne mit offenen bzw. geschlossenen Hohlprofilen können vergleichsweise einfach und mit vergleichsweise geringen Kosten aus einem blechartigen Vormaterial z. B. durch Blechumformung hergestellt werden.

Ein offenes Hohlprofil kann beispielsweise durch einen U-förmig gebogenen Materialabschnitt des Kerns ausgebildet sein. Bei einem insgesamt U-förmigen Kern mit zwei Schenkeln und einer zwischen den Schenkeln verlaufenden Basis, können die Basis als ebener Verbindungssteg und die Schenkel als U-Profile mit einander zugewandten Öffnungen ausgebildet sein. Hohlprofile haben den Vorteil, dass das Gewicht des gesamten Sensors deutlich reduziert werden kann. Rechteckige Hohlprofile ermöglichen durchaus ausreichende Sensorgenauigkeiten und Zuverlässigkeiten.

Nach einer besonders bevorzugten Variante wird der Kern durch eine Kraft, vorzugsweise eine elastische Kraft, bevorzugt eine Federkraft, auf die zweite axiale Anlagefläche gedrückt. Auf diese weise können Spannungen und Verspannungen, die bei anderen Befestigungsarten bei Temperaturschwankungen ansonsten durch unterschiedliche Ausdehnungskoeffizienten von Kern und Spulenträger verursacht würden, vermieden werden.

Nach einer weiteren Variante ist der Kern als U-Kern ausgebildet. Im Falle eines U-Kerns mit zwei Schenkeln und einer die Schenkel verbindenden Basis ist jeder Schenkel zumindest teilweise in einer Ausnehmung eines jeweiligen Spulenträgers angeordnet, derart, dass der jeweilige Schenkel konzentrisch, d. h. mittig bzw. zentral, zur Spulenwicklung und mit der Spulenwicklung überlappend gelegen ist.

Im Falle eines U-Kerns kann die Basis als eine Art Grundplatte ausgebildet sein, von welcher die Schenkel in gleicher Richtung vorspringen. Ein Anpressen des Kerns an die zweiten axialen Anlageflächen bedeutet in diesem Fall, dass die Schenkel, genauer von der Basis abgewandt gelegene Stirnseiten der Schenkel, an bzw. auf die zweite axiale Anlagefläche gedrückt werden. Dazu kann die Basis selbst mit einer Kraft, insbesondere einer elastischen Kraft, insbesondere einer Federkraft, beaufschlagt werden.

Nach einer weiteren Variante wird der Kern, insbesondere der U-Kern, mittels eines mit dem zumindest einen Spulenträger lösbar verbindbaren, insbesondere verrastbaren, Halteelements gehaltert. Das Halteelement kann beispielsweise an einer den ersten und zweiten axialen Anlageflächen abgewandt gelegenen Seite des Spulenträgers gelegen sein. Entsprechend können Befestigungsmittel für das Halteelement, beispielsweise Schnappelemente und dergleichen, vorgesehen sein, die insbesondere eine besonders einfache Montage ermöglichen.

Insbesondere ist es möglich, dass eine den Kern bzw. die Schenkel in jeweilige Ausnehmungen, bzw. auf die jeweiligen zweiten axialen Anlageflächen drückende bzw. pressende Kraft durch das Halteelement und/oder durch eine das Halteelement beaufschlagende elastische Kraft, insbesondere eine Federkraft, insbesondere eine das Halteelement gegen den zumindest einen Spulenträger drückende Kraft, erzeugt wird. Durch ein federndes bzw. elastisches Anpressen des Kerns an die jeweiligen zweiten axialen Anlageflächen können der Kern und der Spulenträger einerseits ausreichend fest miteinander verbunden werden. Andererseits ist die Verbindung zwischen Kern und Spulenträger ausreichend elastisch, so dass durch unterschiedliche thermische Ausdehnungskoeffizienten hervorgerufene Spannungen und Verspannungen in einem weiten Temperaturbereich vermieden werden können.

Eine Federkraft, welche den Kern bzw. die Schenkel in Richtung der jeweiligen zweiten axialen Anlagefläche presst kann beispielsweise durch eine vom Sensor umfasste Feder erzeugt werden, welche das Halteelement unmittelbar, und damit den dem Halteelement nachgeschalteten Kern mittelbar, mit einer Federkraft beaufschlagt.

Nach einer weiteren Variante weist der Sensor des Weiteren ein Gehäuse auf, in welchem der zumindest eine Spulenträger und Kern aufgenommen sind. Vorzugsweise ist das Gehäuse derart ausgebildet, dass die Feder, mit welcher das Halteelement mit Federkraft beaufschlagt werden kann, am Halteelement einerseits und am Gehäuse andererseits abgestützt ist.

Nach einer noch weiteren Variante weist der zumindest eine Spulenträger eine, der Ausnehmung abgewandt gelegene axiale Stirnfläche auf, welche, vorzugsweise durch die Feder, gegen eine Gehäuseinnenwandung des Gehäuses gedrückt wird. Dadurch können in einfacher Weise, und insbesondere durch eine einzige Feder, der Kern in Richtung Spulenträger und damit der Spulenträger in Richtung und auf die Gehäuseinnenwandung gepresst werden. Das ist von besonderem Vorteil im Hinblick auf unterschiedliche Längenänderungen von Gehäuse, Spulenträger und Kern bei Temperaturänderungen. Ferner kann erreicht werden, dass Gehäuseinnenwandung und axiale Stirnfläche sowie Stirnfläche der Schenkel und zweite axiale Anlagefläche stets spiel- und spaltfrei aneinander anliegen.

Insgesamt zeigt sich, dass der vorgeschlagene Sensor, welcher als Abstands- oder Näherungssensor verwendet werden kann, vergleichsweise einfach und kostengünstig hergestellt werden kann. Ferner kann der Sensor automatisiert, insbesondere in Massenfertigung, hergestellt werden. Darüber hinaus weist der vorgeschlagene Sensor eine vorteilhafte Genauigkeit und Zuverlässigkeit auf.

Nachfolgend werden Ausführungsbeispiele der Erfindung anhand der anliegenden Zeichnungen näher beschrieben. Es zeigen:
- Fig. 1: eine Explosionsdarstellung eines Sensors;
- Fig. 2: eine erste Schnittansicht des Sensors;
- Fig. 3: eine zweite Schnittansicht des Sensors;
- Fig. 4: den Sensor im montierten Zustand;
- Fig. 5: eine erste Ausführungsform des Kerns; und
- Fig. 6: eine zweite Ausführungsform des Kerns
- Fig. 7: zwei Spulenträger des Näherungssensors;
- Fig. 8: die Spulenträger mit Kern;
- Fig. 9: die Spulenträger mit Kern und Halteelement; und
- Fig. 10: ein Detail des Spulenträgers und Halteelements;

In den Figuren werden gleiche oder funktionsgleiche Elemente durchwegs mit den gleichen Bezugszeichen bezeichnet. Die Figuren sind nicht zwingend maßstabsgetreu, und Maßstäbe zwischen einzelnen Figuren können variieren. Ferner wird ein in den Figuren gezeigter Sensor als Näherungs- oder Abstandssensor zumindest nur insoweit beschrieben, als zum Verständnis der Erfindung erforderlich ist. Im Allgemeinen kann der Näherungs- bzw. Abstandssensor weitere, im Folgenden nicht weiter beschriebene oder erwähnte Elemente aufweisen.

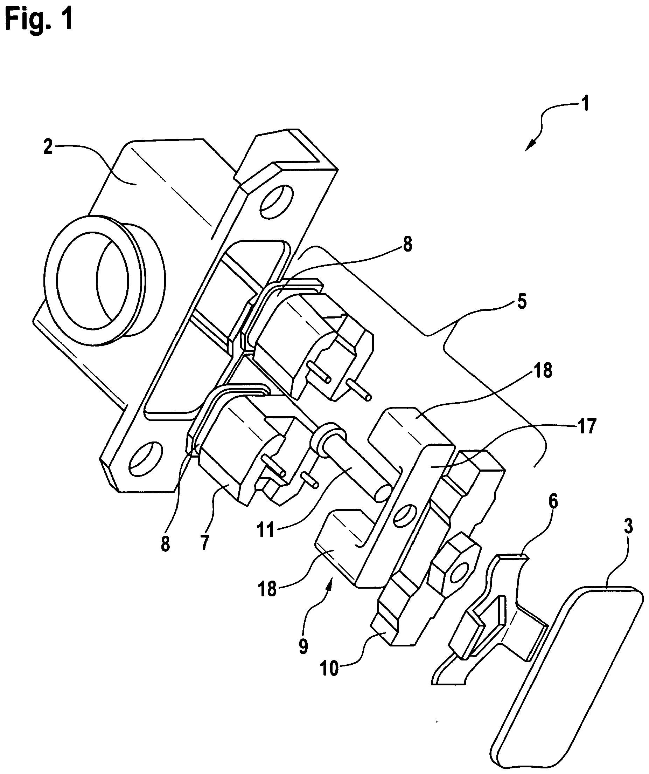

Fig. 1 zeigt eine Explosionsdarstellung eines Näherungs- oder Abstandssensors 1, welcher im Folgenden als Näherungssensor 1 bezeichnet wird. Der Näherungssensor 1 umfasst ein Gehäuse mit einem Gehäusedeckel 2 und einen in eine bodenseitige Öffnung 3 des Gehäusedeckels 2 einsetzbaren Gehäuseboden 4.

In dem Gehäuse sind eine induktive Sensoreinheit 5 und eine die Sensoreinheit 5 mit einer Federkraft beaufschlagende Feder 6 aufgenommen.

Die Sensoreinheit 5 umfasst zwei Spulenträger 7 mit je einer Spulenwicklung 8. Ferner umfasst die Sensoreinheit 5 einen U-förmigen Kern 9 , sprich einen U-Kern 9, und ein Halteelement 10. Mittels des Halteelements 10 wird der U-Kern 9 an den Spulenträgern 7 gehaltert. Die Sensoreinheit 5 umfasst ferner noch eine in das Halteelement 5 einschraubbare Kalibrierschraube 10.

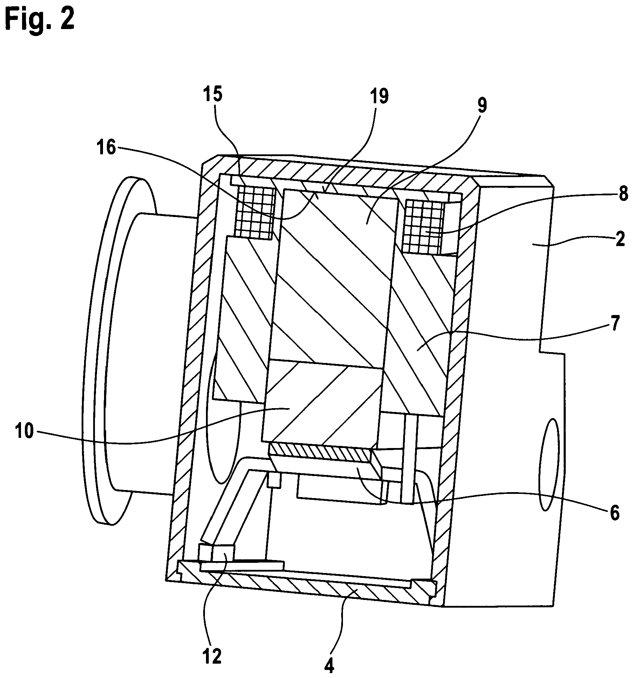

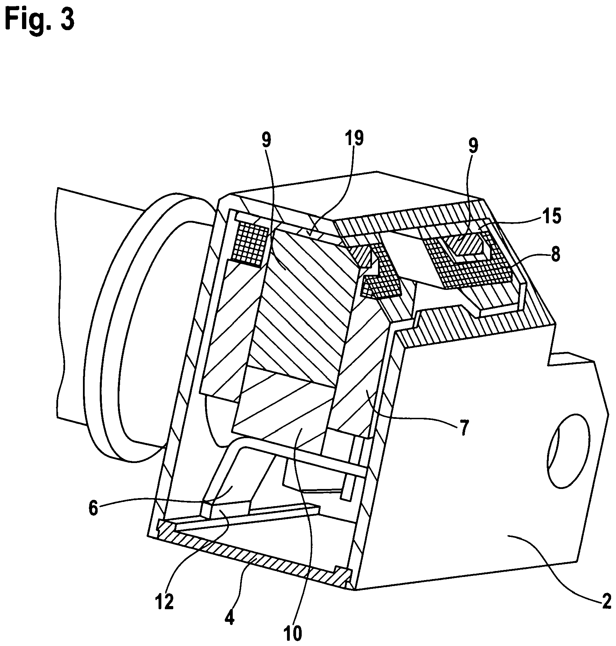

Fig. 2 und 3 zeigen Schnittansichten des Näherungssensors 1. Wie aus Fig. 2 und 3 ersichtlich ist, ist die Feder 6 bogenartig ausgebildet und stützt sich an ihren Enden an Gehäüsevorsprüngen 12 gegenüberliegender Innenseiten des Gehäusedeckels 2 ab.

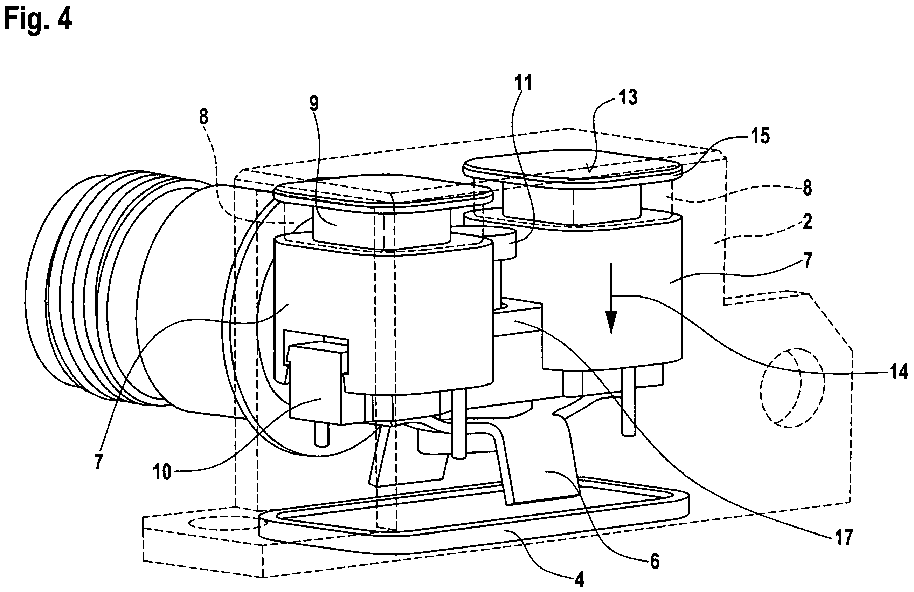

Die Feder 6 beaufschlagt unmittelbar das Halteelement 10, mittelbar die Sensoreinheit 5 mit einer Federkraft derart, dass die Sensoreinheit 5, genauer die Spulenträger 7 in den Gehäusedeckel 2 hinein gedrückt werden. Genauer werden obere Stirnflächen 13 der Spulenträger 7 innenseitig gegen den Gehäusedeckel 2 gedrückt, was insbesondere auch aus Fig. 3 sowie aus und Fig. 4, welche den Näherungssensor 1 im montierten Zustand zeigt, ersichtlich ist.

Insbesondere aus Fig. 2 bis 4 ist auch ersichtlich, dass sich die Spulenwicklung 8 unmittelbar angrenzend an einen stirnseitig gelegenen Axialflansch 15 in axialer Richtung 14 erstreckt. Der Spulenträger 7 weist anschließend an den Axialflansch 15 in axialer Richtung eine umlaufende Vertiefung auf, in welcher die Spulenwicklung 8 aufgenommen ist. Die Spulenwicklung 8 liegt unmittelbar am Axialflansch 15 an, welcher für die Spulenwicklung 8 damit eine erste axiale Anlagefläche 16 ausbildet.

Der U-Kern 9, genauer zwei von einer Basis 17 des U-Kerns 9 vorspringende Schenkel 18 sind in jeweilige Ausnehmungen 22 der Spulenträger 7 eingeführt. Die Schenkel 18 liegen etwa konzentrisch in den Ausnehmungen 22 und überlappen im Bereich umlaufenden Vertiefung mit der jeweiligen Spulenwicklung 8. Vorzugsweise füllen die Schenkel 18 die Ausnehmungen 22 im Wesentlichen voll aus.

Die Schenkel 18, genauer in Richtung der oberen Stirnfläche 13 des Spulenträgers 7 weisende Schenkel-Stirnflächen 19 der Schenkel 18, liegen in den Ausnehmungen 22 an zweiten axialen Anlagenflächen an, welche jeweils zu den ersten axialen Anlageflächen 16 im Wesentlichen koplanar sind. Die zweiten axialen Anlageflächen werden durch die Böden der Ausnehmungen 22 gebildet und liegen im Wesentlichen in einer Ebene mit der ersten axialen Anlagefläche 16. Anders ausgedrückt reichen die Ausnehmungen 22 bis zu der Ebene, in welcher die erste axiale Anlagefläche 16 liegt. Das führt dazu, dass die relative Lage der oberen, d. h. die der ersten 16 und zweiten axialen Anlagefläche zugewandten, Kanten der Schenkel 18 und Spulenwicklungen 8 stets auf gleichem Niveau liegen. Dadurch kann im Wesentlichen unabhängig von temperaturbedingten Längenänderungen des Spulenträgers 7 und der Schenkel 18 usw. eine besonders genaue und exakte Betriebsweise erzielt werden.

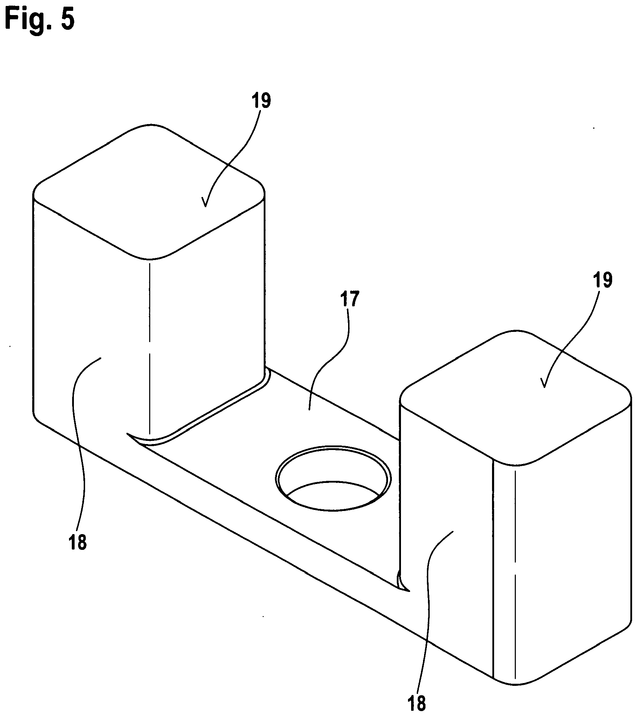

Fig. 5 zeigt eine erste Ausführungsform des U-Kerns 9. Daraus ist erkennbar, dass die Schenkel 18 an voneinander entfernten Enden der Basis 17 gelegen sind und in gleiche Richtung von der Basis 17 vorspringen. Im vorliegenden Beispiel weisen die Schenkel 18 über deren gesamte Länge ein rechteckförmiges Querschnittsprofil, d. h. einen rechteckförmigen Axialschnitt auf. Der Axialschnitt ist im vorliegenden Beispiel bei genauerer Betrachtung in Form eines Quadrats mit abgerundeten Ecken, was im Sinne der Erfindung insbesondere als "rechteckförmig" verstanden werden soll.

Der U-Kern 9, insbesondere die Schenkel 18, ist/sind im Beispiel der Fig. 5 aus Vollmaterial hergestellt, d. h. dass das Axialprofil bzw. Querschnittsprofil ein Vollprofil ist. Kerne dieser Art können insbesondere aus Vollmaterial hergestellt werden.

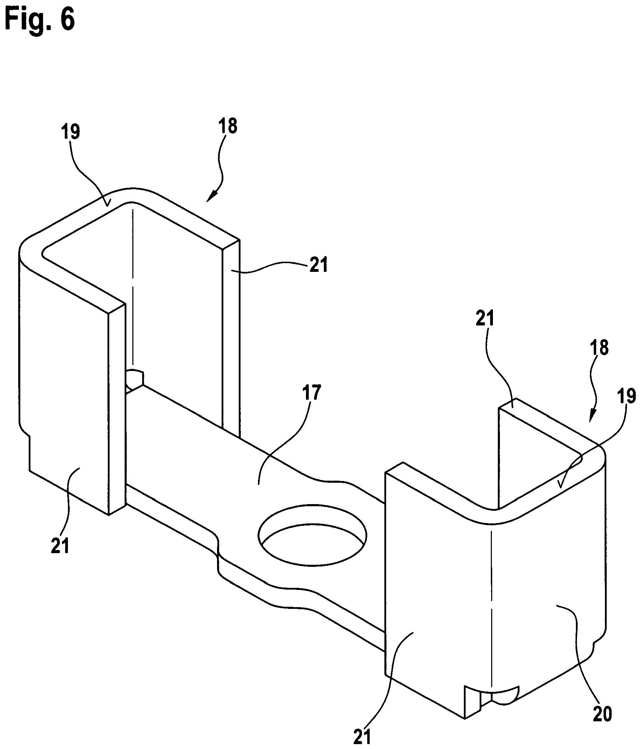

Fig. 6 zeigt eine zweite Ausführungsform des U-Kerns 9. Im Unterschied zum U-Kern 9 der Fig. 5 ist das Axialprofil der Schenkel 18 der Fig. 6 ein offenes Hohlprofil. Bei dem Hohlprofil handelt es sich konkret um ein U-Profil. Das U-Profil wird gebildet durch eine sekundäre Basis 20 und zwei sekundäre Schenkel 21, die im unteren Bereich, d. h. im Bereich der Fußpunkte der Schenkel 21 seitlich an der Basis 17 anliegen. Die Öffnungen der U-Profile der beiden Schenkel 18 sind vorliegend einander zugewandt.

Ein solcher U-Kern 9 mit offenem Hohlprofil kann beispielsweise durch Materialumformung aus einer blechartigen, ebenen Vorform hergestellt werden. Die Vorform selbst kann beispielsweise durch Stanzen, Schneiden, insbesondere Laserschneiden und andere Verfahren hergestellt sein.

Ein etwa in der Mitte der Basis 17 befindliches Loch ist zum Durchgriff der Kalibrierschraube 11 vorgesehen. Im Bereich des Lochs ist die Basis 17 des in Fig. 6 gezeigten U-Kerns 9 lateral verbreitert, wodurch erhöhte mechanische Stabilität erreicht werden kann. Die Verbreiterung ist derart ausgebildet, dass die Verbreiterungsstege lateral nicht über das Niveau der sekundären Schenkel 21 hinausragen.

Es hat sich gezeigt, dass insbesondere mit den oben beschriebenen U-Kernen 9 eine besonders gute Empfindlichkeit, Genauigkeit und Zuverlässigkeit erreicht werden kann.

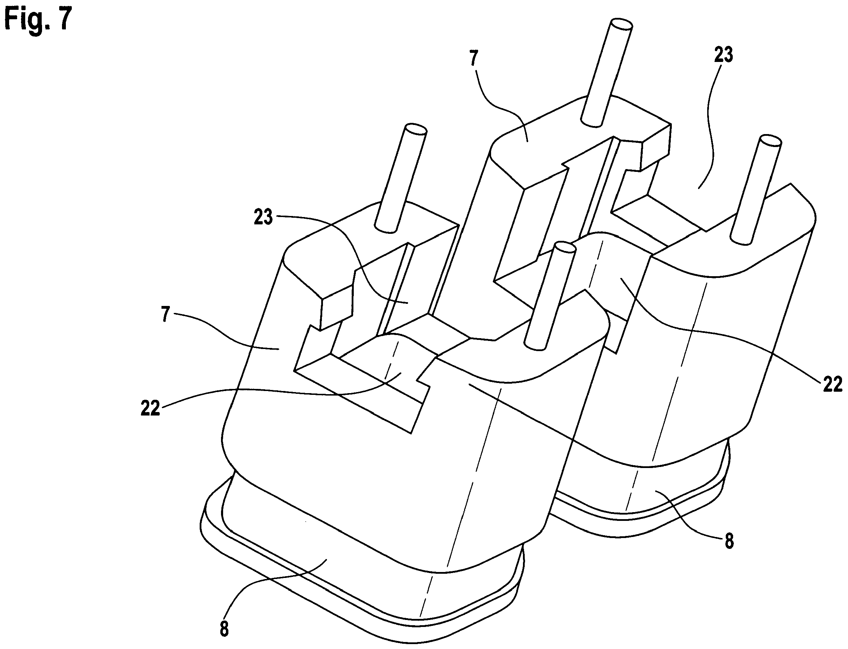

Insbesondere im Hinblick auf Figuren 7 bis 10 wird nachfolgend genauer auf den Zusammenbau und Aufbau des Näherungssensors 1 bzw. der Sensoreinheit 5 eingegangen.

Fig. 7 zeigt beispielhaft zwei Spulenträger 7 des Näherungssensors 1 bzw. der Sensoreinheit 5. Die Spulenträger 7 weisen, wie bereits erwähnt, zur Form der Schenkel 18 korrespondierende, axial etwa mittig gelegene rechteckige Ausnehmungen 22 auf, in welche die Schenkel 18 des U-Kerns 9 eingeführt werden bzw. sind. Ferner weisen die Spulenträger 7 jeweils einen quer zur axialen Richtung 14 verlaufenden Einschnitt 23 auf, der, wie weiter unten noch näher ausgeführt wird, im Zusammenhang mit der Fixierung des U-Kerns 9 an den Spulenträgern 7 von Relevanz ist.

Die axiale Tiefe der Ausnehmungen 22 und die Länge der Schenkel 18 bzw. die Länge der über die Basis 17 überstehenden Abschnitte der Schenkel 18, sind derart aneinander angepasst, dass die Schenkel-Stirnflächen 19 an den zweiten axialen Anlageflächen, welche koplanar mit den ersten axialen Anlageflächen 16 sind, anliegen.

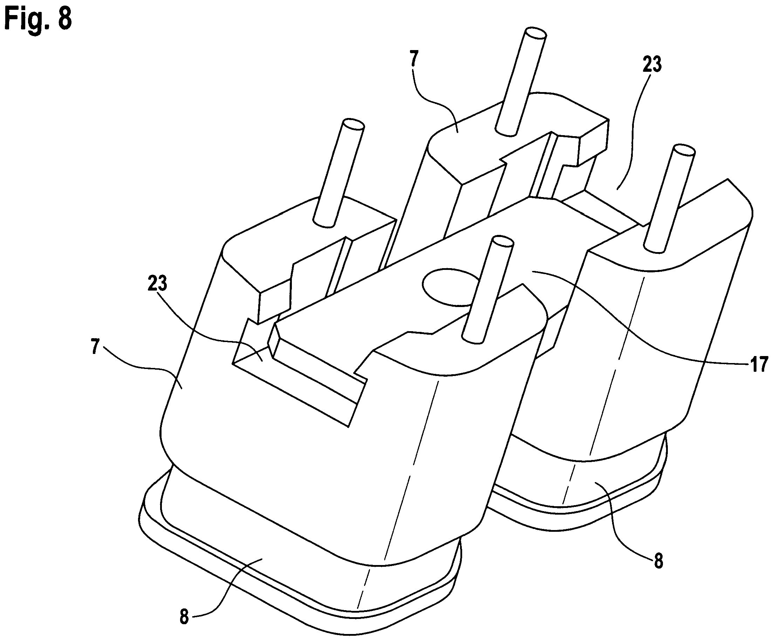

Fig. 8 zeigt die Spulenträger 7 mit eingesetztem U-Kern 9. Wie in Fig. 8 zu sehen ist, weisen die Einschnitte 23 in axialer Richtung 14 eine Tiefe auf, welche größer ist als die Dicke der Basis 17. Die Basis 17 füllt also die Höhe der Einschnitte 23 nicht vollständig aus, so dass oberhalb der Basis 17 Raum für das Halteelement 10 verbleibt.

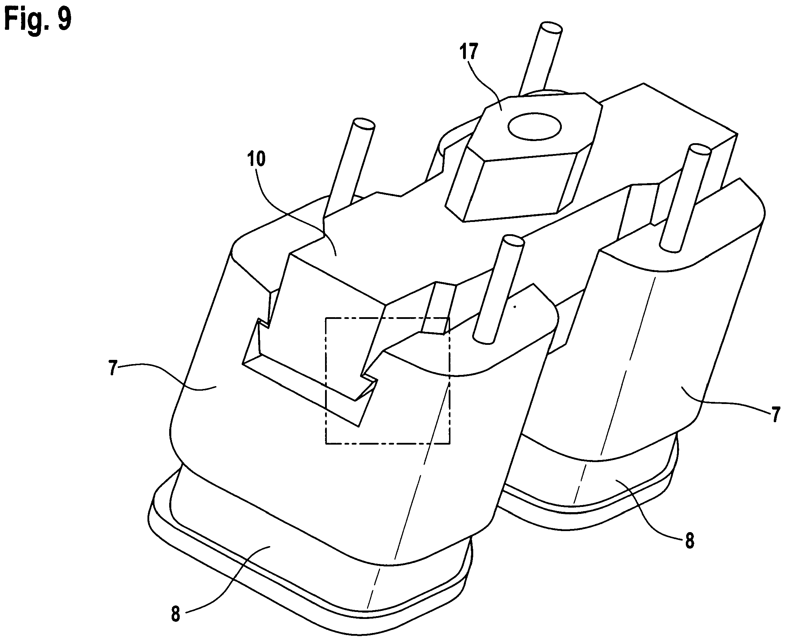

Fig. 9 zeigt die Spulenträger 7 mit eingesetztem U-Kern 9 und Halteelement 10. Das Halteelement 10 ist in die Einschnitte 23 eingesetzt. Die Spulenträger 7 und das Halteelement 10 sind lösbar miteinander verbunden; im vorliegenden Fall mittels Rastelementen miteinander verrastet. Das Halteelement 10, die Einschnitte 23 und die Rastelemente sind derart ausgebildet und eingerichtet, dass bei verrastetem Halteelement 10 der U-Kern 9 und die Spulenträger 7 aneinander gedrückt bzw. gepresst werden. Auf diese Weise werden die Schenkel-Stirnflächen 19 auf die zweite axiale Anlagefläche gedrückt bzw. gepresst.

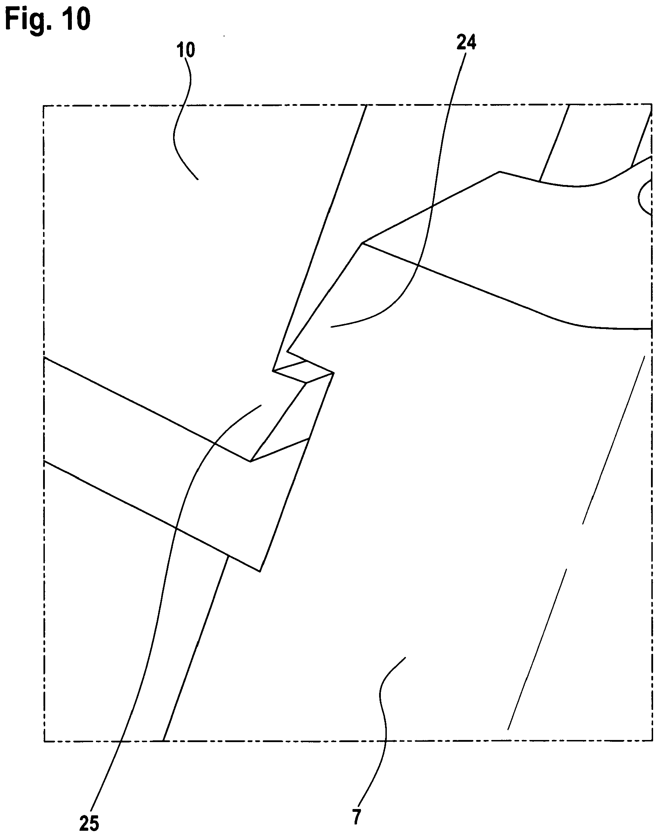

Die Verrastung zwischen Spulenträger 7 und Halteelement 10 ist in Fig. 10, welche den in Fig. 9 markierten Abschnitt vergrößert zeigt, im Detail dargestellt. Als Rastelemente weisen die Spulenträger 7 erste Rastnasen 24 und das Halteelement 10 weist korrespondierende zweite Rastnasen 25 auf, die bei eingesetztem Halteelement 10 miteinander verrasten.

Die Spulenträger 7, insbesondere die Einschnitte 23, das Halteelement 10 und die ersten 24 und zweiten Rastnasen 25 sind derart ausgebildet und angeordnet, dass der U-Kern 9 ohne Spiel zwischen Spulenträgern 7 und Halteelement 10 liegt, und dass die Schenkel-Stirnflächen 19 stets auf der zweiten axialen Anlagefläche zumindest aufliegen, bevorzugt auf die zweiten axialen Anlageflächen gedrückt werden. Dadurch bleibt die relative Lage der der ersten 16 und zweiten axialen Anlagefläche zugewandten Kanten der Spulenwicklungen 8 und U-Kerne 9 konstant, insbesondere bei temperaturschwankungsbedingten Längenänderungen der Komponenten des Näherungssensors 1 bzw. der Sensoreinheit 5. Dadurch kann die Genauigkeit und Zuverlässigkeit des Näherungssensors 1 maßgeblich verbessert werden.

Der Spulenträger 7 und das Halteelement 10 sind vorzugsweise aus einem Kunststoffmaterial, z. B. PEEK, hergestellt. Insbesondere in diesem Fall kann durch die Schnappverbindung zwischen Spulenträgern 7 und Halteelement 10 eine elastische Kraft erzeugt werden, welche den U-Kern 9 in Richtung der zweiten axialen Anlagefläche drückt. Elastische Kräfte sind für die bereits angesprochenen Längenänderungen der Komponenten des Näherungssensors 1 bei Temperaturschwankungen von Vorteil, denn es kann trotz unterschiedlicher thermischer Ausdehnungskoeffizienten von Spulenträgern 7 und U-Kernen 9 stets erreicht werden, dass der U-Kern 9 in Richtung der zweiten axialen Anlagefläche gedrückt wird.

Damit die oberen Stirnflächen 13 der Sensoreinheit 5, genauer der Spulenträger 7, stets an der entsprechenden Gehäuseinnenwandung anliegen, wird, wie insbesondere aus Fig. 1 bis 4 ersichtlich ist, die Sensoreinheit 5 mittels der Feder 6, sprich mittels einer elastischen Kraft, in Richtung der Gehäuseinnenwandung gedrückt. Diese Kraft wirkt zusätzlich und unterstützend zu der durch das Halteelement 10 zwischen U-Kern 9 und Spulenträger 7 wirkenden Kraft auch dahingehend, dass die Schenkel-Stirnflächen 19 gegen die zweite axiale Anlagefläche gedrückt werden. Darüber hinaus wird durch diese Kraft die Sensoreinheit 5 im Gehäuse ausreichend fixiert. Insbesondere kann auch bei temperaturbedingten Längenänderungen von Sensoreinheit 5 und Gehäuse sichergestellt werden, dass die Sensoreinheit 5 an der Gehäuseinnenwandung und die Schenkel-Stirnflächen 19 an der zweiten axialen Anlagefläche in axialer Richtung 14 stets spalt- und spielfrei anliegen.

Insgesamt zeigt sich, dass mit dem Näherungssensor 1 im Speziellen, dem Sensor im Allgemeinen, insbesondere durch Aufbau und Geometrie des Sensors und dessen einzelner Komponenten, die der Erfindung zu Grunde liegende Aufgabe gelöst wird.

### Bezugszeichenliste

- 1: Näherungssensor
- 2: Gehäusedeckel
- 3: bodenseitige Öffnung
- 4: Gehäuseboden
- 5: Sensoreinheit
- 6: Feder
- 7: Spulenträger
- 8: Spulenwicklung
- 9: U-Kern
- 10: Halteelement
- 11: Kalibrierschraube
- 12: Gehäusevorsprung
- 13: obere Stirnfläche
- 14: axiale Richtung
- 15: Axialflansch
- 16: erste axiale Anlagefläche
- 17: Basis
- 18: Schenkel
- 19: Schenkel-Stirnfläche
- 20: sekundäre Basis
- 21: sekundärer Schenkel
- 22: Ausnehmung
- 23: Einschnitt
- 24: erste Rastnase
- 25: zweite Rastnase

## Patentansprüche

1. Sensor (1) mit einer induktiven Sensoreinheit (5), umfassend zumindest einen Spulenträger (7) mit einer darauf befindlichen Spulenwicklung (8) zur Erzeugung eines Magnetfelds und zumindest einen Kern (9), wobei sich die Spulenwicklung (8) in axialer Richtung unmittelbar angrenzend an eine erste axiale Anlagefläche (16) des Spulenträgers, deren Normalenvektor in axialer Richtung verläuft, (7) erstreckt, wobei der Kern (9) zumindest teilweise in einer Ausnehmung (22) im Spulenträger (7) konzentrisch und überlappend mit der Spulenwicklung (8) angeordnet ist und an einer durch einen Boden der Ausnehmung (22) gebildeten zweiten axialen Anlagefläche, deren Normalenvektor ebenfalls in axialer Richtung verlauft, anliegt, wobei zumindest ein mit der Spulenwicklung (8) überlappender Kernabschnitt des zumindest einen Kerns (9) ein rechteckförmiges Querschnittsprofil aufweist, **dadurch gekennzeichnet, dass** die zweite axiale Anlagefläche zur ersten axialen Anlagefläche (16) koplanar ist.

2. Sensor (1) nach Anspruch 1, wobei das Querschnittsprofil zumindest eines Kernabschnitts ein Vollprofil ist.

3. Sensor (1) nach einem der vorangehenden Ansprüche, wobei das Querschnittsprofil zumindest eines Kernabschnitts ein geschlossenes oder ein offenes Hohlprofil ist.

4. Sensor (1) nach einem der vorangehenden Ansprüche, wobei der Kern (9) durch eine Kraft, vorzugsweise eine elastische Kraft, bevorzugt eine Federkraft, in Richtung der zweiten axialen Anlagefläche gedrückt wird.

5. Sensor (1) nach einem der vorangehenden Ansprüche, wobei der Kern (9) als U-Kern (9) mit zwei Schenkeln (18) und einer die Schenkel (18) verbindenden Basis (17) ausgebildet ist, wobei jeder Schenkel (18) zumindest teilweise in einer Ausnehmung (22) eines jeweiligen Spulenträgers (7), vorzugsweise konzentrisch, überlappend mit der Spulenwicklung (8) angeordnet sind.

6. Sensor (1) nach einem der vorangehenden Ansprüche, wobei von der Basis (17) abgewandt gelegene Stirnseiten (19) der Schenkel (18), bevorzugt durch Beaufschlagung der Basis (17) mit einer Kraft, auf jeweilige zweite axiale Anlageflächen gedrückt werden.

7. Sensor (1) nach einem der vorangehenden Ansprüche, wobei der Kern (9), insbesondere der U-Kern (9), mittels eines mit dem zumindest einen Spulenträger (7) lösbar verbindbaren, insbesondere verrastbaren, Halteelements (10) gehaltert wird.

8. Sensor (1) nach Anspruch 7, wobei eine den Kern (9) bzw. die Schenkel (18) in jeweilige Ausnehmungen (22) und/oder die Sensoreinheit (5) in Richtung der Gehäuseinnenwandung eines Gehäuses (2, 4,) des Sensors (1) drückende Kraft durch das Halteelement (10) und/oder durch eine das Halteelement (10) beaufschlagende elastische Kraft, insbesondere eine Federkraft, insbesondere eine das Halteelement (10) gegen den zumindest einen Spulenträger (7) drückende Kraft, erzeugt wird.

9. Sensor (1) nach einem der vorangehenden Ansprüche, umfassend des Weiteren eine das Halteelement (10) mit einer Federkraft beaufschlagende Feder (6).

10. Sensor (1) nach einem der vorangehenden Ansprüche, umfassend des Weiteren ein Gehäuse (2, 4), in welchem der zumindest eine Spulenträger (7) und Kern (9) aufgenommen sind, wobei vorzugsweise die Feder (6) am Halteelement (10) einerseits und am Gehäuse (2) andererseits abgestützt ist.

11. Sensor (1) nach einem der vorangehenden Ansprüche, wobei der zumindest eine Spulenträger (7) eine, der Ausnehmung (22) abgewandt gelegene axiale Stirnfläche (13) aufweist, welche, vorzugsweise durch die Feder (6), gegen eine Gehäuseinnenwandung des Gehäuses (2) gedrückt wird.

## Claims

1. Sensor (1) having an inductive sensor unit (5) comprising at least one coil carrier (7), with a coil winding (8) situated thereon for generating a magnetic field, and at least one core (9), the coil winding (8) extending in the axial direction directly adjacent to a first axial contact surface (16) of the coil carrier (7), the normal vector of which runs in the axial direction, the core (9) being at least partially arranged in a recess (22) in the coil carrier (7) in a concentric manner and in such a manner that it overlaps the coil winding (8) and resting against a second axial contact surface which is formed by a base of the recess (22) and the normal vector of which likewise runs in the axial direction, at least one core section of the at least one core (9), which overlaps the coil winding (8), having a rectangular cross-sectional profile, **characterized in that** the second axial contact surface is coplanar with respect to the first axial contact surface (16).

2. Sensor (1) according to Claim 1, the cross-sectional profile of at least one core section being a solid profile.

3. Sensor (1) according to one of the preceding claims, the cross-sectional profile of at least one core section being a closed or open hollow profile.

4. Sensor (1) according to one of the preceding claims, the core (9) being pressed in the direction of the second axial contact surface by a force, preferably an elastic force, preferably a spring force.

5. Sensor (1) according to one of the preceding claims, the core (9) being designed as a U-core (9) with two limbs (18) and a base (17) connecting the limbs (18), each limb (18) being at least partially arranged in a recess (22) in a respective coil carrier (7), preferably in a concentric manner and in such a manner that it overlaps the coil winding (8).

6. Sensor (1) according to one of the preceding claims, ends (19) of the limbs (18) which face away from the base (17) being pressed onto respective second axial contact surfaces, preferably by applying a force to the base (17).

7. Sensor (1) according to one of the preceding claims, the core (9), in particular the U-core (9), being held using a holding element (10) which can be detachably connected, in particular latched, to the at least one coil carrier (7).

8. Sensor (1) according to Claim 7, a force which presses the core (9) or the limbs (18) into respective recesses (22) and/or presses the sensor unit (5) in the direction of the inner wall of a housing (2, 4) of the sensor (1) being generated by the holding element (10) and/or by an elastic force which is applied to the holding element (10), in particular a spring force, in particular a force which presses the holding element (10) against the at least one coil carrier (7).

9. Sensor (1) according to one of the preceding claims, also comprising a spring (6) which applies a spring force to the holding element (10).

10. Sensor (1) according to one of the preceding claims, also comprising a housing (2, 4) in which the at least one coil carrier (7) and the core (9) are accommodated, the spring (6) preferably being supported on the holding element (10), on the one hand, and on the housing (2), on the other hand.

11. Sensor (1) according to one of the preceding claims, the at least one coil carrier (7) having an axial end face (13) which faces away from the recess (22) and is preferably pressed against an inner wall of the housing (2) by the spring (6).

## Revendications

1. Capteur (1) comportant une unité de détection à induction (5), comprenant au moins un support de bobine (7) ayant un enroulement de bobine (8) se trouvant sur celui-ci pour générer un champ magnétique et au moins un noyau (9), dans lequel l'enroulement de bobine (8) s'étend dans la direction axiale de manière immédiatement adjacente à une première surface d'installation axiale (16) du support de bobine (7) dont le vecteur normal s'étend dans la direction axiale, dans lequel le noyau (9) est disposé au moins en partie dans un évidement (22) ménagé dans le support de bobine (7) concentriquement et de manière à se superposer à l'enroulement de bobine (8) et est adjacent à une deuxième surface d'installation axiale formée à travers un fond de l'évidement (22), dont le vecteur normal s'étend également dans la direction axiale, dans lequel au moins une partie de noyau de l'au moins un noyau (9) chevauchant l'enroulement de bobine (8) présente un profil de section transversale rectangulaire, **caractérisé en ce que** la deuxième surface d'installation axiale est coplanaire par rapport à la première surface d'installation axiale (16).

2. Capteur (1) selon la revendication 1, dans lequel le profil de section transversale d'au moins une partie de noyau est un profil plein.

3. Capteur (1) selon l'une quelconque des revendications précédentes, dans lequel le profil de section transversale d'au moins une partie du noyau est un profil creux fermé ou ouvert.

4. Capteur (1) selon l'une quelconque des revendications précédentes, dans lequel le noyau (9) est comprimé par une force, de préférence une force élastique, préférablement une force de ressort, dans la direction de la deuxième surface d'installation axiale.

5. Capteur (1) selon l'une quelconque des revendications précédentes, dans lequel le noyau (9) est réalisé sous la forme d'un noyau en U (9) comportant deux branches (18) et une base (17) reliant les branches (18), dans lequel chaque branche (18) est disposée au moins en partie dans un évidement (22) d'un support de bobine respectif (7), de préférence concentriquement et de manière à se superposer à l'enroulement de bobine (8).

6. Capteur (1) selon l'une quelconque des revendications précédentes, dans lequel des faces avant (19) des branches (18), disposées de manière opposée à la base (17), sont de préférence comprimées en soumettant la base (17) à une force sur des deuxièmes surfaces d'installation axiales respectives.

7. Capteur (1) selon l'une quelconque des revendications précédentes, dans lequel le noyau (9), notamment le noyau en U (9), est soutenu au moyen d'un élément de support (10) pouvant être relié, et pouvant notamment être encliqueté, de manière amovible à l'au moins un support de bobine (7).

8. Capteur (1) selon la revendication 7, dans lequel une force comprimant le noyau (9) ou la branche (18) dans des évidements respectifs (22) et/ou l'unité de détection (5) dans la direction de la paroi interne de boîtier d'un boîtier (2, 4) du capteur (1) est produite par l'élément de support (10) et/ou par une force élastique exercée sur l'élément de support (10), notamment une force de ressort, en particulier une force comprimant l'élément de support (10) contre l'au moins un support de bobine (7).

9. Capteur (1) selon l'une quelconque des revendications précédentes, comprenant en outre un ressort (6) soumettant l'élément de support (10) à une force de ressort.

10. Capteur (1) selon l'une quelconque des revendications précédentes, comprenant en outre un boîtier (2, 4) dans lequel sont logés l'au moins un support de bobine (7) et le noyau (9), dans lequel le ressort (6) est supporté d'une part par l'élément de support (10) et d'autre part par le boîtier (2).

11. Capteur (1) selon l'une quelconque des revendications précédentes, dans lequel l'au moins un support de bobine (7) comporte une surface avant (13) axiale disposée de manière opposée à l'évidement (22), qui est de préférence comprimée par le ressort (6) contre une paroi interne de boîtier du boîtier (2).
